**Europäisches Patentamt**

**European Patent Office**

**Office européen des brevets**

(19)

(11) Veröffentlichungsnummer: **0 031 494**
**B1**

(12) **EUROPÄISCHE PATENTSCHRIFT**

(45) Veröffentlichungstag der Patentschrift:
**19.10.83**

(51) Int. Cl.³: **H 01 L 31/02, H 01 L 25/04**

(21) Anmeldenummer: **80107622.5**

(22) Anmeldetag: **04.12.80**

(54) Solarzellenanordnung.

(30) Priorität: **28.12.79 US 107947**

(43) Veröffentlichungstag der Anmeldung:
**08.07.81 Patentblatt 81/27**

(45) Bekanntmachung des Hinweises auf die Patenterteilung:
**19.10.83 Patentblatt 83/42**

(84) Benannte Vertragsstaaten:
**DE FR GB**

(56) Entgegenhaltungen:
**EP-A-0 012 217**
**US-A-3 484 606**
**US-A-3 591 420**
**US-A-4 190 465**

(73) Patentinhaber: **International Business Machines
Corporation, Old Orchard Road, Armonk, N.Y. 10504 (US)**

(72) Erfinder: **Hodgson, Rodney Trevor, 822 Pines Bridge
Road, Ossining New York 10562 (US)**
Erfinder: **Hovel, Harold John, Diane Court, Katonah New
York 10598 (US)**

(74) Vertreter: **Schröder, Otto H., Dr.-Ing., c/o International
Business Machines Corporation Zurich Patent
Operations Säumerstrasse 4, CH-8803 Rüschlikon/ZH
(CH)**

BUNDESDRUCKEREI BERLIN

Solarzellenanordnung

Die Erfindung betrifft eine Solarzellenanordnung, bestehend aus Gruppen von in Serie geschalteten Solarzellen, die eine Last mit der Serienspannung versorgen.

Eine einzelne Solarzelle liefert eine elektrische Spannung in der Größenordnung der Bandlücke des verwendeten Halbleiters. Um höhere Spannungen zu erhalten, ist es daher notwendig, eine Anzahl von Solarzellen in Serie zu schalten. Die Ausgangsspannung einer solchen Gruppe von Solarzellen ist die Summe der einzelnen Spannungsanteile, die von den einzelnen Zellen geliefert werden. Ein mögliches Problem besteht darin, daß bei einer Serienschaltung der gelieferte Strom nur dem des schwächsten Gliedes der Kette entsprechen kann. Wenn bei einer Solarzellenanordnung beispielsweise eine am Rande liegende Zelle nicht die volle Strahlung erhält, so kann sie nur einen geringeren Strom liefern und setzt somit den Gesamtstrom der Anordnung herab.

Es ist bekannt, bei Solarzellen fluoreszierendes Material als Überzug oder Zwischenschicht zu verwenden, das kurzwellige Anteile des einfallenden Lichtes in Fluoreszenzlicht im Arbeitsbereich der Solarzelle umwandelt. Es wird beispielsweise auf die US-Patentschrift 3 484 606 verwiesen. Die Ausbeute der Solarzelle wird auf diese Weise erhöht.

Es ist bis jetzt jedoch noch keine Solarzellenanordnung bekanntgeworden, bei der die Stärke des einfallenden Lichtes bezüglich der Oberfläche der Anordnung örtlich verschieden beeinflußt wird.

Die Solarzellenanordnung nach der Erfindung ist durch die Patentansprüche definiert.

Die Erfindung wird nachfolgend anhand von Beispielen mit Hilfe der Zeichnungen näher erläutert.

Fig. 1 zeigt schematisch eine Gruppe von Solarzellen, die in Serie geschaltet sind und eine Last mit der Serienspannung versorgen.

Fig. 2 ist eine graphische Darstellung der Intensität des einfallendes Lichtes in Abhängigkeit vom Abstand vom Zentrum der Einstrahlung.

Fig. 3 zeigt schematisch eine Solarzellenanordnung nach der Erfindung und darüber eine graphische Darstellung der Verteilung der Lichtintensität.

Fig. 4 ist eine graphische Darstellung der Verteilung der Lichtintensität in Abhängigkeit vom Abstand vom Zentrum sowohl des einfallenden als auch des re-emittierten Lichtes.

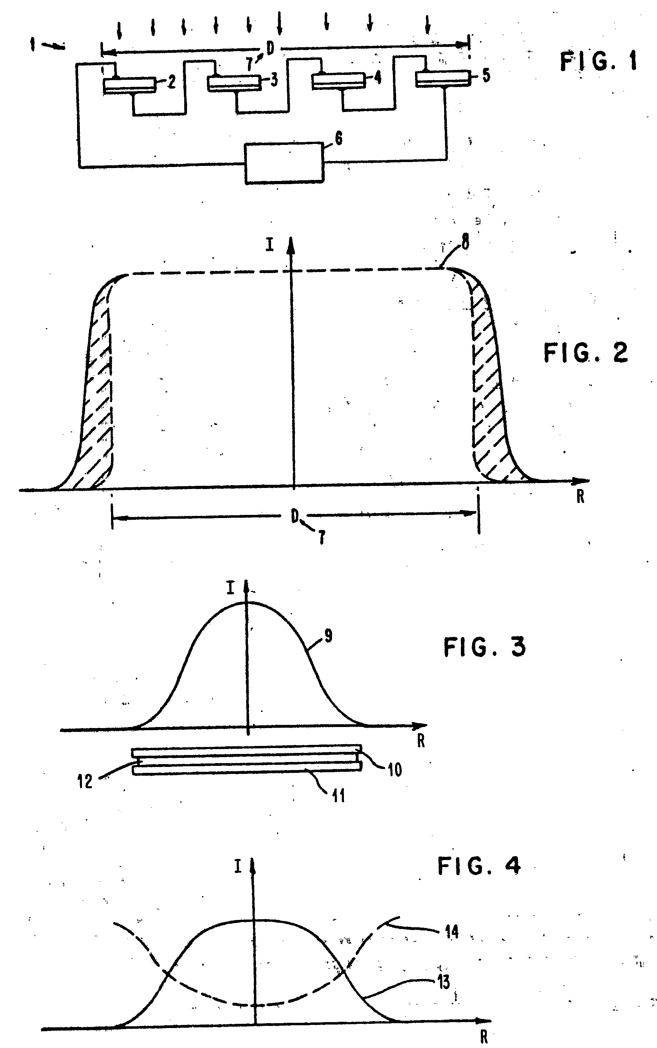

In der Fig. 1 ist schematisch eine Solarzellengruppe 1 dargestellt, deren einzelne Solarzellen 2, 3, 4 und 5 in Serie geschaltet sind, um eine Last 6 mit der Serienspannung zu versorgen. Die gesamte Solarzellenmatrix, von der lediglich die Gruppe 1 dargestellt ist, ist zweidimensional ausgelegt. In der Zeichnung ist nur eine Dimension 7 und ihr Durchmesser D gezeigt. Durch die Hintereinanderschaltung der Solarzellen ist sichergestellt, daß der Last 6 eine erhöhte Spannung zugeführt wird. Eine Reihenschaltung hat bekanntlich die Eigenschaft, daß der Gesamtstrom dadurch begrenzt ist, daß er nicht größer sein kann, als der Strom, den die schwächste Zelle der Reihenschaltung liefert. Es ist daher notwendig, dafür zu sorgen, daß jede Solarzelle einen gleichen Anteil der einfallenden Strahlung erhält.

In der Fig. 2 zeigt eine Kurve 8 die Intensität I des Lichtes als Funktion des Abstandes R vom Zentrum der Einstrahlung bei einer der bisher gebräuchlichen Anordnungen. Diese verwenden Mittel zur Konzentration des Lichtes. Ein schraffiertes Gebiet von etwa 20% der Gesamtmenge des Lichtes zeigt den Strahlungsanteil, der unwirksam ist und damit verlorengeht.

Um dieses schraffierte Gebiet so klein wie möglich zu machen, ist eine spezielle Optik mit beispielsweise asphärischen Linsen erforderlich. Bei den bekannten Einrichtungen machen sich Fehler in der Nachführung der Anordnung mit der Bewegung der Sonne drastisch bemerkbar, wenn dadurch am Rande liegende Solarzellen weniger Strahlung erhalten. In der Darstellung nach Fig. 2 würde dem eine Verschiebung der Kurve in bezug auf die zentrale Achse gleichbedeutend sein.

In der Fig. 3 zeigt eine Kurve 9 die Abhängigkeit der Intensität I des Lichtes vom Abstand R bei einer Anordnung, die ein mehr gebräuchliches System für die Lichtkonzentration verwendet. Das bedeutet eine einfache Optik und weniger strenge Anforderungen an die Nachführung der Anordnung mit der Bewegung der Sonne. Eine fluoreszierende Schicht 10 ist dargestellt in Verbindung mit einer Solarzellengruppe 11, der Art, wie sie in der Fig. 1 dargestellt ist. Die fluoreszierende Schicht 10 läßt die langwelligen Anteile des einfallenden Lichts 9 direkt zu den Solarzellen durch und absorbiert Anteile der einfallenden Strahlung mit kürzeren Wellenlängen. Die absorbierte Strahlungsenergie wird dann durch die Schicht 10 als Licht mit größerer Wellenlänge re-emittiert. Nahezu alles so re-emittierte Licht findet seinen Weg in die Solarzellengruppe 11. Eine Schicht 12 aus den Brechungsindex anpassenden Material ist zwischen der fluoreszierenden Schicht 10 und der Solarzellengruppe 11 vorgesehen. Wenn der Brechungsindex der Schicht 12 an allen Stellen gleich ist, wird der Anteil des Fluoreszenzlichtes gleichmäßig auf die Solarzellengruppe 11 verteilt, weil das re-emittierte Licht im Mittel mehrere innere Reflexionen erfährt, bevor es in die Solarzellengruppe einfällt. Die aus dem durchgelassenen und dem re-emittierten Anteil bestehende Gesamtstrahlung ist dann gleichmäßiger verteilt als die Intensität 9 des einfallenden Lichtes allein.

Wenn jedoch die Einrichtung so getroffen wird, daß die Schicht 12 des den Brechungsindex anpassenden Materials eine ungleichmäßige Verteilung des Brechungsindex aufweist, in der Weise, daß sie im mittleren Bereich niedrig ist und mit der Entfernung von der Mitte anwächst, dann wird das re-emittierte Fluoreszenzlicht wirkungsvoller zu den Randbereichen geleitet als zu den mittleren Bereichen der Anordnung. So kann die Gleichmäßigkeit der Gesamtstrahlung wesentlich verbessert werden.

Die F i g. 4 ist eine Darstellung der beiden Anteile des verwendeten Lichtes. Die graphische Darstellung zeigt in einer ausgezogenen Kurve 13 den direkt übertragenen Lichtfluß. Die gestrichelte Kurve 14 zeigt den re-emittierten Lichtfluß, der durch das fluoreszente Material 10 umgewandelt wurde. Gegebenenfalls wird die Verteilung dieses Lichtanteils noch durch das Material der Schicht 12 in einer Weise verändert, daß die in die Solarzellenanordnung einfallende Gesamtstrahlung noch gleichmäßiger verteilt ist. Die Summe der beiden Lichtflüsse nach den Kurven 13 und 14 ist die Gesamtstrahlung, die in die Solarzellengruppe 11 einfällt.

Es folgen einige nützliche Angaben für die Umsetzung der Erfindung in die Praxis. Jede Solarzelle kann aus Silizium hergestellt sein. Eine Gruppe von N Zellen, wobei N eine beliebige Zahl beispielsweise im Bereich von 4 bis 120 ist, werden in Reihe geschaltet und liefern eine erhöhte Spannung an die Last 6 in der Größenordnung von etwa 0,5 N Volt. Wenn die Solarzellen beispielsweise aus Galliumarsenid bestehen, dann liegt die Ausgangsspannung der Reihenschaltung einer Gruppe solcher Zellen in der Größenordnung von etwa N Volt. Die das Licht konzentrierenden Linsen haben Abmessungen von etwa 15 bis 45 cm in Länge und Breite. Der mittlere Durchmesser D einer Solarzellenanordnung liegt in der Größenordnung von etwa 1 bis 5 cm.

Als fluoreszierende Schicht 10 verwendet man zweckmäßig mit Chrom dotiertes Aluminiumoxyd, das als Rubin bekannt ist. Auch mit seltenen Erden dotierte Gläser sind verwendbar. Für die Schicht 12 zur Anpassung des Brechungsindex verwendet man Materialien auf der Grundlage von Silizium oder Silikon. Der Zusatz von dotierendem Material in den Schichten liegt in der Größenordnung von 0,1% – 10%.

**Patentansprüche**

1. Solarzellenanordnung, bestehend aus Gruppen von in Serie geschalteten Solarzellen, die eine Last mit der Serienspannung versorgen, dadurch gekennzeichnet, daß oberhalb der Solarzellengruppen (11) in der Einfallsrichtung des Lichtes eine fluoreszierende Schicht (10) vorgesehen ist, die kurzwellige Anteile des einfallenden Lichtes in Fluoreszenzlicht im Arbeitsbereich der Solarzellen umwandelt, und daß zwischen der fluoreszierenden Schicht (10) und den Solarzellengruppen (11) eine den Brechungsindex anpassende Zwischenschicht (12) derart angeordnet ist, daß das gesamte Licht aus einfallender Strahlung mit re-emittierter umgewandelter Strahlung in gleichmäßiger räumlicher Verteilung in den Solarzellengruppen (11) wirksam wird.

2. Anordnung nach Anspruch 1, dadurch gekennzeichnet, daß das fluoreszierende Material aus Aluminiumoxyd besteht mit einem Anteil von 0,1% bis 10% Chromionen.

3. Anordnung nach Anspruch 2, dadurch gekennzeichnet, daß die Solarzellen aus Silizium bestehen.

4. Anordnung nach Anspruch 2, dadurch gekennzeichnet, daß die Solarzellen aus Galliumarsenid bestehen.

5. Anordnung nach Anspruch 1, dadurch gekennzeichnet, daß die Solarzellen aus halbleitendem Galliumarsenid auf einem halbisolierenden Substrat aus Galliumarsenid bestehen.

6. Anordnung nach Anspruch 1, dadurch gekennzeichnet, daß der Brechungsindex der Zwischenschicht (12) örtlich variiert.

**Claims**

1. Solar cell arrangement comprising groups of series-connected solar cells that supply a series voltage to a load, characterized in that a fluorescent layer (10) is provided, above the groups of solar cells (11) and in the direction of incidence of the light, which operates to convert the short-wave portion of the impinging light to fluorescent radiation in the sensitivity range of the solar cells, and that a refractive index matching material (12) is interposed between the fluorescent layer (10) and the solar cell groups (11) such that the total light consisting of the impinging radiation and the re-emitted converted radiation is uniformly distributed over the groups of solar cells.

2. An arrangement as claimed in claim 1, characterized in that the fluorescent layer consists of aluminium oxide doped with 0,1% to 10% chromium ions.

3. An arrangement as claimed in claim 2, characterized in that the solar cells are made of silicon.

4. An arrangement as claimed in claim 2, characterized in that the solar cells are made of gallium arsenide.

5. An arrangement as claimed in claim 1, characterized in that the solar cells consist of semiconducting gallium arsenide deposited on a semi-isolating substrate of gallium arsenide.

6. An arrangement as claimed in claim 1, characterized in that the refractory index of the interposed material (12) is non-uniform.

**Revendications**

1. Arrangement de cellules solaires comportant des groupes de cellules solaires montées en série qui alimentent en tension une charge, caractérisé en ce qu'il est prévu une couche fluorescente (10) au-dessus des groupes de cellules solaires (11) dans la direction de la lumière incidente, en ce que le spectre des ondes courtes de la lumière incidente est converti en lumière fluorescente dans le champ d'action des cellules solaires, en ce qu'une couche intermédiaire (12) correspondant à l'indice de réfraction est disposée entre la source fluorescente (10) et les groupes de cellules solaires (11) et en ce qu'un faisceau lumineux composé de rayons incidents et de rayons convertis réfractés, est réparti de façon uniforme sur les groupes de cellules solaires (11).

2. Arrangement selon la revendication 1, caractérisé en ce que la matière fluorescente est de l'oxyde d'aluminium comportant des ions chromique dans une proportion allant de 0,1 à 10%.

3. Arrangement selon la revendication 2, caractérisé en ce que les cellules solaires sont en silicium.

4. Arrangement selon la revendication 2, caractérisé en ce que les cellules solaires sont en arséniure de gallium.

5. Arrangement selon la revendication 1, caractérisé en ce que les cellules solaires sont composées d'arséniure de gallium semi-conducteur déposé sur un substrat semiisolant d'arséniure de gallium.

6. Arrangement selon la revendication 1, caractérisé en ce que l'indice de réfraction de la couche intermédiaire (12) varie localement.

FIG. 1

FIG. 2

FIG. 3

FIG. 4